# EUROPEAN PATENT APPLICATION

(11) **EP 4 134 467 A1**
(43) Date of publication of application: **15.02.2023**
(21) Application number: 21209365.2
(22) Date of filing: 19.11.2021
(51) Int. Cl.: C23C 4/10, C23C 4/137, C23C 24/04, C23C 4/11, B05B 7/22, B05B 12/08, B05B 12/12, B05B 13/02

(54) **CERAMIC COATING SYSTEM AND METHOD**

(30) Priority: 10.08.2021 KR 20210105115
(71) Applicant: Lee, Chang Hoon, Seoul 03477 (KR)
(72) Inventor: Lee, Chang Hoon, Seoul 03477 (KR)
(74) Representative: Bongiovanni, Simone

(57) **Abstract**

A ceramic coating system using an atmospheric pressure plasma generator is provided, which includes a vacuum chamber configured to maintain a vacuum therein, a support disposed inside the vacuum chamber and fixedly supporting a substrate, a plasma generator that generates active species through plasma discharge and includes a nozzle part wherein at least a portion of the nozzle part is disposed to face the substrate inside the vacuum chamber, and a particle providing apparatus that transfers ceramic particles to one side of the nozzle part.

## Description

### CROSS-REFERENCE TO RELATED APPLICATION

This application claims priority under 35 U.S.C §119 to Korean Patent Application No. 10-2021-0105115, filed in the Korean Intellectual Property Office on August 10, 2021, the entire contents of which are hereby incorporated by reference.

### BACKGROUND OF THE INVENTION

### Field of Invention

The present disclosure relates to a ceramic coating system and method, and more particularly, to a ceramic coating system and method using an atmospheric pressure plasma generator.

### Description of Related Art

Plasma is an ionized gas of electrons, neutral particles, or the like, and part of the plasma gas has high energy that can change the surface of materials. That is, the plasma may react directly with the surface of another material or react by elastic collision. A plasma generator mainly includes a tube configured to generate plasma as a compressed air or nitrogen gas are collided with high-frequency, high-voltage electric charges.

In recent years, in place of low pressure or vacuum plasma, use of atmospheric pressure plasma devices has increased. The atmospheric pressure plasma device may be applied to various materials and substrates through a low-temperature process, and since a vacuum container or a vacuum evacuation device is not required, fast and economic treatment is provided. In addition, since a deposition method using the atmospheric pressure plasma provides good adhesion and has a low deposition temperature, it is used in relatively various industries by utilizing the advantages such as reduction in deformation or denaturation that accompanies high temperature heating in the related surface treatment process, semiconductor process, and display process.

### BRIEF SUMMARY OF THE INVENTION

Embodiments disclosed herein provide a ceramic coating system and method capable of sintering a surface of ceramic particles using an atmospheric pressure plasma generator.

A ceramic coating system using an atmospheric pressure plasma generator according to an embodiment may include a vacuum chamber configured to maintain a vacuum therein, a support disposed inside the vacuum chamber and fixedly supporting a substrate, a plasma generator that generates active species through plasma discharge and includes a nozzle part wherein at least a portion of the nozzle part is disposed to face the substrate inside the vacuum chamber, and a particle providing apparatus that transfers ceramic particles to one side of the nozzle part.

According to an embodiment, a surface of the ceramic particles is sintered by a plasma gas including the active species in the nozzle part, and as the plasma gas is discharged into the vacuum chamber through the nozzle part, the ceramic particles with the sintered surface are deposited on the substrate.

According to an embodiment, the ceramic particles correspond to ceramic particles used for Aerosol Deposition (AD).

According to an embodiment, the particle providing apparatus may include a passage part connected at one side to the nozzle part and configured to move the ceramic particles to the nozzle part using a carrier gas injected from the other side, and a containing part configured to contain the ceramic particles therein and provide the ceramic particles to the passage part.

According to an embodiment, the support may include a robot arm that fixedly supports the substrate at one end and the robot arm may be configured to adjust a distance between the nozzle part and the substrate.

According to an embodiment, the ceramic coating system may further include a speed measuring sensor configured to measure an ejection speed of the ceramic particles in the vacuum chamber, and a controller that controls a driving intensity of the plasma generator based on the ejection speed measured by the speed measuring sensor.

According to an embodiment, the ceramic coating system may further include a thickness measuring sensor configured to measure a thickness of the ceramic particles deposited on the substrate, and a controller that controls whether or not the plasma generator and the particle providing apparatus are driven, based on the deposition thickness of the ceramic particles measured by the thickness measuring sensor.

A ceramic coating method using an atmospheric pressure plasma generator according to another embodiment may include by a plasma generator including a nozzle part plasma-discharging a discharge gas to generate active species, by a particle providing apparatus injecting ceramic particles to one side of the nozzle part formed inside a vacuum chamber, sintering a surface of the ceramic particles by the active species in the nozzle part, and spraying the ceramic particles with the sintered surface through the nozzle part for deposition coating on a substrate in the vacuum chamber.

According to an embodiment, the method may further include adjusting a distance between the nozzle part and the substrate by a support that fixedly supports the substrate from one side.

According to an embodiment, the method may further include, by a speed measuring sensor, measuring an ejection speed of the ceramic particles in the vacuum chamber, by a thickness measuring sensor, measuring a thickness of the ceramic particles deposited on the substrate, by a controller, controlling a driving intensity of the plasma generator based on the ejection speed measured by the speed measuring sensor, and by the controller, controlling whether or not the plasma generator and the particle providing apparatus are driven, based on the deposition thickness of the ceramic particles measured by the thickness measuring sensor.

According to various embodiments of the present disclosure, when this ceramic coating system is used, the ceramic particles can be instantaneously exposed to ultra-high temperature plasma at the nozzle part, and can be changed into a spherical sintered state having a larger diameter than that of general ceramic particles. In this case, by using the sintered ceramic particles for the AD coating, a deposition layer can be formed quickly and evenly and the loss rate of the ceramic particles deposited on the substrate is reduced compared to the related AD coating, thereby increasing productivity and also reducing costs.

In addition, according to various embodiments of the present disclosure, since the distance between the nozzle part and the substrate is adjustable by the robot arm, it is possible to easily deposit the ceramic particles on the substrate.

In addition, according to various embodiments of the present disclosure, when the plasma generator is driven in a low vacuum state, it is possible to easily sinter the ceramic particles.

In addition, according to various embodiments of the present disclosure, since it is possible to check in real time whether or not the moving speed of the ceramic particles falls to or below a reference value by using the speed measuring sensor, it is possible to reduce the deposition loss rate of the ceramic particles.

Further, according to various embodiments of the present disclosure, it is possible to check in real time whether or not the coating thickness of the ceramic particles is equal to or greater than a reference value by using a thickness measuring sensor.

The effects of the present disclosure are not limited to the effects described above, and other effects that are not mentioned above can be clearly understood to those skilled in the art based on the description provided below.

### BRIEF DESCRIPTION OF THE DRAWINGS

The above and other objects, features and advantages of the present disclosure will become more apparent to those of ordinary skill in the art by describing in detail exemplary embodiments thereof with reference to the accompanying drawing, in which:
FIG. 1 is a schematic diagram of a ceramic coating system using an atmospheric pressure plasma generator according to an embodiment;
FIG. 2 is a schematic diagram of a ceramic coating system using an atmospheric pressure plasma generator according to another embodiment;
FIG. 3 is a front view schematically illustrating a plasma generator and a particle providing apparatus according to an embodiment;
FIG. 4 is a flowchart illustrating a ceramic coating method using an atmospheric pressure plasma generator according to an embodiment; and
FIG. 5 is a flowchart illustrating a ceramic coating method using an atmospheric pressure plasma generator according to another embodiment.

### DETAILED DESCRIPTION OF THE INVENTION

Hereinafter, specific details for the practice of the present disclosure will be described in detail with reference to the accompanying drawings. However, in the following description, detailed descriptions of well-known functions or configurations will be omitted when it may make the subject matter of the present disclosure rather unclear.

In the accompanying drawings, the same or corresponding elements are assigned the same reference numerals. In addition, in the following description of the embodiments, duplicate descriptions of the same or corresponding components may be omitted. However, even if descriptions of components are omitted, it is not intended that such components are not included in any embodiment.

The terms used in the present disclosure will be briefly described prior to describing the disclosed embodiments in detail. The terms used herein have been selected as general terms which are widely used at present in consideration of the functions of the present disclosure, and this may be altered according to the intent of an operator skilled in the art, conventional practice, or introduction of new technology. In addition, in specific cases, the term may be arbitrarily selected by the applicant, and the meaning of the term will be described in detail in a corresponding description of the embodiments. Therefore, the terms used in the present disclosure should be defined based on the meaning of the terms and the overall content of the present disclosure rather than a simple name of each of the terms.

In the present disclosure, the singular forms "a," "an," and "the" are intended to include the plural forms as well, unless the context clearly indicates the singular forms. Further, the plural forms are intended to include the singular forms as well, unless the context clearly indicates the plural forms.

In the present disclosure, when a portion is stated as "comprising (including)" a component, unless specified to the contrary, it intends to mean that the portion may additionally comprise (or include or have) another component, rather than excluding the same.

In the present disclosure, it is to be noted that the upper direction of the drawing may be referred to as "upper portion" or "upper side" of the configuration shown in the drawing, and the lower direction may be referred to as "lower portion" or "lower side". In addition, in the drawings, a portion between the upper and lower portions of the configuration shown in the drawings, or a portion other than the upper and lower portions may be referred to as "side portion" or "side". Relative terms such as "upper portion" and "upper side" may be used to describe the relationship between components shown in the drawings, and the present disclosure is not limited by these terms.

In the present disclosure, a direction toward the inner space of a structure may be referred to as "inside", and a direction projecting into the open outer space may be referred to as "outside". Relative terms such as "inside" and "outside" may be used to describe the relationship between components shown in the drawings, and the present disclosure is not limited by these terms.

As used herein, the statement "A and/or B" means A, or B, or A and B.

Throughout the description, when a portion is stated as being connected to another portion, it intends to include not only an example in which the portions are directly connected, but also an example in which the portions are connected while having another component disposed therebetween.

Advantages and features of the disclosed embodiments and methods of accomplishing the same will be apparent by referring to embodiments described below in connection with the accompanying drawings. However, the present disclosure is not limited to the embodiments disclosed below, and may be implemented in various different forms, and the present embodiments are merely provided to make the present disclosure complete, and to fully disclose the scope of the invention to those skilled in the art to which the present disclosure pertains.

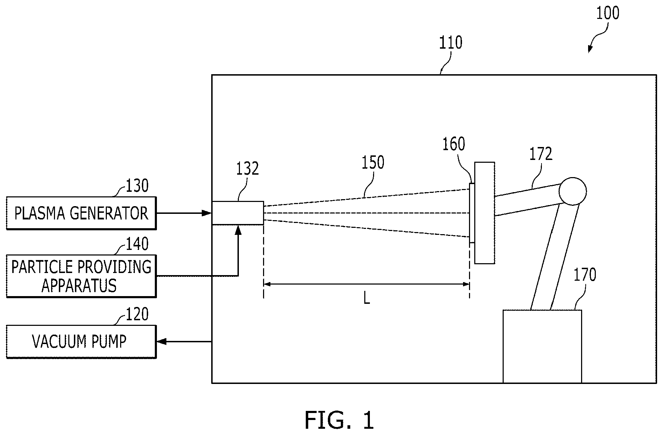

FIG. 1 is a schematic diagram of a ceramic coating system 100 using an atmospheric pressure plasma generator 130 according to an embodiment.

As illustrated in FIG. 1, the ceramic coating system 100 may include a vacuum chamber 110, a support 170, a plasma generator 130, and a particle providing apparatus 140.

The vacuum chamber 110 may be an apparatus of which inside is maintained in a vacuum by a vacuum pump 120. In this case, the vacuum pump 120 may be formed on one side of the vacuum chamber 110 to suck the air inside the vacuum chamber 110 so as to keep the inside of the vacuum chamber 110 substantially in a vacuum state. The inside of the vacuum chamber 110 may correspond to a space in which a substrate 160 or the like is coated with ceramic particles 150 or ceramic powder (hereinafter, collectively referred to as "ceramic particles"). In an embodiment, the vacuum chamber 110 may be installed in a fixed position, or may be detachably provided on specific mounting equipment and the like.

The support 170 for fixedly supporting the substrate 160 may be disposed inside the vacuum chamber 110. In an embodiment, the support 170 may include a robot arm 172 that fixedly supports the substrate 160 at one end. The robot arm 172 may be configured to be three-dimensionally movable to adjust a distance L, an angle, and the like between a nozzle part 132 and the substrate 160. For example, the robot arm 172 may use a two-axis robot arm to adjust the distance L to facilitate the deposition coating of the ceramic particles 150 on the substrate 160. In another example, the robot arm 172 may move the substrate 160 to any position within the vacuum chamber 110.

The plasma generator 130 may be an apparatus for plasma-discharging a discharge gas to generate active species and discharging the plasma gas including the active species. In an embodiment, the plasma generator 130 may be an atmospheric pressure plasma generator. In an embodiment, the plasma generator 130 may include the nozzle part 132. The nozzle part 132 may include a discharge port through which the plasma gas and the ceramic particles 150 are discharged into the vacuum chamber 110. In an embodiment, at least a portion of the nozzle part 132 may be disposed to face the substrate 160 from the inside of the vacuum chamber 110. Accordingly, the plasma gas and the ceramic particles 150 discharged from the plasma generator 130 may be discharged toward the substrate 160.

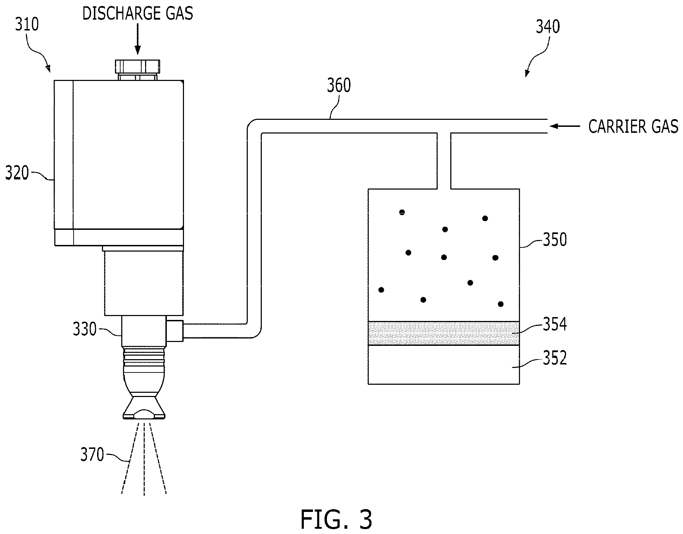

The particle providing apparatus 140 may be an apparatus that transfers the ceramic particles 150 to one side of the nozzle part 132 with a carrier gas. Specifically, one end of the particle providing apparatus 140 may be connected to the nozzle part 132 inside the vacuum chamber 110, thereby transferring the carrier gas and the ceramic particles 150 to the inside of the nozzle part 132. In this case, the ceramic particles 150 may correspond to an aggregated form suitable for an aerosol deposition (AD) deposition method. In addition, the ceramic particles 150 may be the ceramic particles used with the AD method. For example, the ceramic particles 150 may correspond to silicon particles or yttrium oxide (Y2O3) particles. A detailed configuration of a lower portion of the particle providing apparatus 140 will be described in detail with reference to FIG. 3.

According to an embodiment, the surfaces of the ceramic particles transferred to the nozzle part 132 may be sintered by the plasma gas including the active species generated by the plasma generator 130. Specifically, as the discharge gas flowing into one side of the nozzle part 132 is plasma discharged, active species are generated, and the surfaces of the ceramic particles flowing into the other side of the nozzle part 132 may be sintered by the active species. In an embodiment, when the plasma generator 130 is driven in a low vacuum state rather than the atmospheric pressure state, the ceramic particles may be easily sintered. For example, as compared to the plasma with a beam length of about 20 mm under the general atmospheric pressure, the plasma in the low vacuum state is discharged with a very long beam length of about 40 to 60 mm, which can facilitate the sintering of the ceramic particles.

In an embodiment, as the plasma gas is discharged into the vacuum chamber 110 through the nozzle part 132, the ceramic particles 150 with the sintered surfaces may be deposited on the substrate 160. Accordingly, one side of the substrate 160 may be coated with the ceramic particles 150 by the deposition coating. In the related art where the agglomerated ceramic particles are coated in a vacuum state by the AD method, there is a problem of a considerably high loss rate of particles deposited on the substrate. However, when the ceramic coating system 100 in this embodiment is used, the ceramic particles may be instantaneously exposed to ultra-high temperature plasma at the nozzle part 132, and thus may be changed into a spherical sintered state having a larger diameter than that of general ceramic particles. In this case, by using the sintered ceramic particles 150 for the AD coating, a deposition layer can be formed quickly and evenly and the loss rate of the ceramic particles 150 deposited on the substrate 160 is reduced compared to the related AD coating, thereby increasing productivity and also reducing costs.

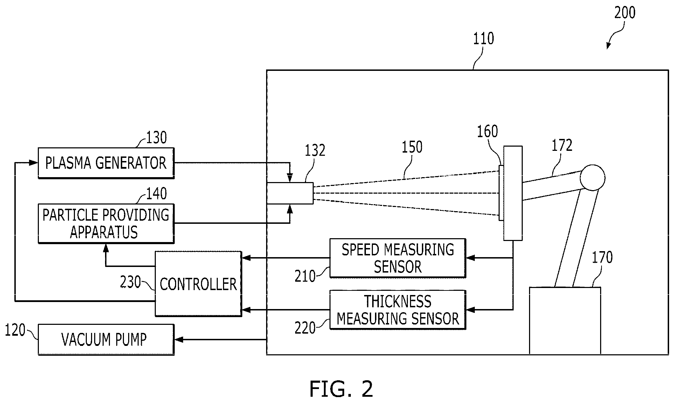

FIG. 2 is a schematic diagram of a ceramic coating system 200 using the atmospheric pressure plasma generator 130 according to another embodiment. Among the configurations illustrated in FIG. 2, descriptions of the configurations corresponding to those of FIG. 1 will be omitted.

As illustrated in FIG. 2, the ceramic coating system 200 may include the vacuum chamber 110, the vacuum pump 120, the plasma generator 130, the particle providing apparatus 140, the support 170, a speed measuring sensor 210, a thickness measuring sensor 220, and a controller 230. In the ceramic coating system 200, the controller 230 receiving a signal from the speed measuring sensor 210 and/or the thickness measuring sensor may control the plasma generator 130 and/or the particle providing apparatus 140, thereby adjusting the speed of the ceramic particles 150 moving from the nozzle part 132 to the substrate 160 and the deposition thickness of the ceramic particles 150 on the substrate 160. In an embodiment, the controller 230 may correspond to a control unit including a microprocessor.

In an embodiment, the speed measuring sensor 210 may be installed inside the vacuum chamber 110. The speed measuring sensor 210 may be configured to measure the moving speed of the ceramic particles 150 moving from the nozzle part 132 to the substrate 160 in the vacuum chamber 110. For example, the speed measuring sensor 210 may include an electric resistive type or electric capacitive type speed measuring sensor which is capable of outputting an electrical signals according to the moving speed of the ceramic particles 150, but is limited thereto no. In order to lower the deposition loss rate of the ceramic particles 150 on the substrate 160, the speed measuring sensor 210 may be operated to check in real time whether or not the moving speed of the ceramic particles 150 falls to or below a reference value. The speed measuring sensor 210 may transmit an electrical signal determined according to the moving speed of the ceramic particle 150 to a controller 260.

In an embodiment, the thickness measuring sensor 220 may be installed inside the vacuum chamber 110. The thickness measuring sensor 220 installed inside the vacuum chamber 110 may be configured to measure a deposition thickness of the ceramic particles 150 on the substrate 160. For example, the thickness measuring sensor 220 may include an optical sensor capable of changing electrical conductivity according to the deposition thickness of the ceramic particles 150 and outputting an electrical signal or an image sensor capable of capturing an image of a deposited film of the ceramic particles 150 and measuring a thickness thereof, and/or an image signal processor, but is not limited thereto. The thickness measuring sensor 220 may be operated to check in real time whether or not a coating thickness of the ceramic particles 150 deposited on the substrate 160 is equal to or greater than a reference value. The thickness measuring sensor 220 may transmit an electrical signal determined according to the thickness of the ceramic particle 150 deposited on the substrate 160 to the controller 260.

The controller 230 may receive the electrical signal transmitted from the speed measuring sensor 210 and/or the thickness measuring sensor 220, and determine whether the moving speed of the ceramic particles 150 and/or the thickness of the ceramic particles 150 deposited on the substrate 160 is equal to or greater than, or equal to or less than a reference value. According to the moving speed or deposition thickness of the ceramic particles 150 determined as described above, the controller 230 may control whether or not the plasma generator 130 and/or the particle providing apparatus 140 is driven, and driving time and intensity thereof. For example, when the controller 230 determines that the moving speed of the ceramic particle 150 is equal to or less than the reference value (e.g., sonic or subsonic) based on the electrical signal of the speed measuring sensor 210, the controller 230 may increase the driving intensity of the plasma generator 130. In addition, when the controller 230 determines that the deposition thickness of the ceramic particles 150 on the substrate 160 is equal to or greater than the reference value based on the electrical signal of the thickness measuring sensor 220, the controller 230 may stop the operation of the plasma generator 130 and/or the particle providing apparatus 140. As described above, with the controller 230 controlling the operation of the plasma generator 130 and/or the particle providing apparatus 140, the loss rate of the ceramic particles 150 applied on the substrate 160 by the deposition coating can be significantly reduced, and the ceramic coating speed can be increased.

FIG. 3 is a front view schematically illustrating a plasma generator 310 and a particle providing apparatus 340 according to an embodiment. The plasma generator 310 and the particle providing apparatus 340 illustrated in FIG. 3 may be used as the plasma generator 130 and the particle providing apparatus 140 of the ceramic coating systems 100 and 200 illustrated in FIGS. 1 and 2.

In an embodiment, the plasma generator 310 may be an atmospheric pressure plasma generator. In this case, the plasma generator 310 may include a generator, a high voltage transformer, electrodes for generating plasma discharge, and the like so as to be driven in a normal room temperature/atmospheric pressure environment. Specifically, the plasma generator 310 may include a nozzle part 330 through which plasma is discharged, a gas supply pipe (not shown) where the nozzle part 330 is attached to or detached from one side and a working gas (or discharge gas, plasma gas) is supplied from the other side, and a body portion 320 to and from which a cable or the like connected to a high voltage transformer (not shown) is attached and detached.

In an embodiment, the high frequency high voltage generated by the high voltage transformer may be applied to the electrodes installed inside the body portion 320, and a high frequency discharge in the form of an electric arc may be generated between the electrodes by the applied voltage. As described above, with the electric arc being generated inside the body portion 320, the working gas may contact the electric arc and be converted into the plasma state. The plasma beam generated in the body portion 320 may be discharged through an opening of the nozzle part 330. In this case, as the working gas, one or more gases may be used alone or in combination according to the characteristics of the ceramic particles. For example, the working gas may be any one of nitrogen, argon, oxygen, hydrogen, helium, fluorine, or a combination thereof.

In an embodiment, the particle providing apparatus 340 may include a containing part 350 and a passage part 360. The containing part 350 may contain the ceramic particles 354 therein. In an embodiment, the containing part 350 may move the ceramic particles 354 to the passage part 360 using a vibrator 352 formed therein. The passage part 360 may be connected at one side to the nozzle part 330. The passage part 360 may be configured to move the ceramic particles 354 to the nozzle part 330 using a carrier gas injected from the other side of the passage part 360. In this case, the carrier gas may include Ar and/or N2. In an embodiment, the passage part 360 may have a tube or pipe shape.

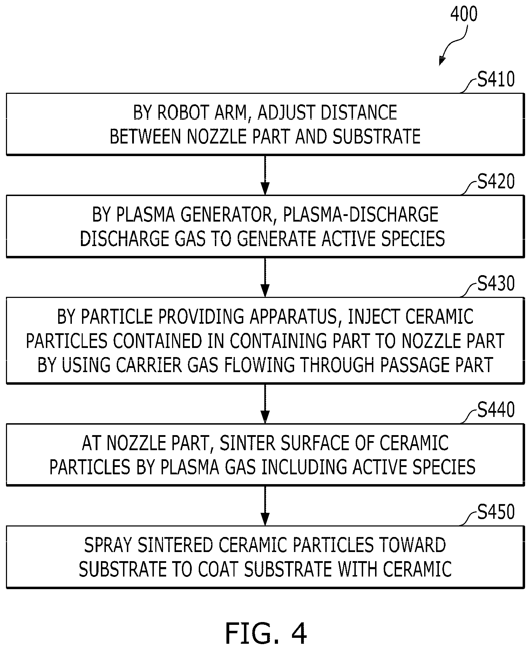

FIG. 4 is a flowchart illustrating a ceramic coating method 400 using the atmospheric pressure plasma generator according to an embodiment.

The ceramic coating method 400 may be initiated by adjusting a distance between the nozzle part and the substrate in the vacuum chamber by the robot arm, at S410. In an embodiment, referring to FIG. 1, the robot arm 172 may adjust a distance L between the nozzle part 132 and the substrate 160. Specifically, the robot arm 172 may be configured to adjust the distance L between the nozzle part 132 and the substrate 160 such that the ceramic particles 150 are easily deposited on the substrate 160.

Next, the discharge gas may be plasma-discharged by the plasma generator to generate active species, at S420. In an embodiment, referring to FIGS. 1 and 3, the active species may be generated by plasma-discharging the discharge gas flown into the plasma generator 130. The plasma gas including the active species generated by the plasma generator 130 may be discharged into the vacuum chamber 110 through the nozzle part 132 formed in the vacuum chamber 110.

Subsequently, the carrier gas may be flown into the nozzle part by the particle providing apparatus 140, S430. In an embodiment, referring to FIGS. 1 and 3, the particle providing apparatus 140 and 340 uses the carrier gas flowing along the passage part 360 connected to the nozzle part 132 and 330 to inject the ceramic particles contained in the containing part 350 into the nozzle part 132 and 330.

Next, the plasma gas including the active species in the nozzle part may sinter the surface of the ceramic particles flowing into the nozzle part from the particle providing apparatus, at S440. In an embodiment, referring to FIGS. 1 and 3, the plasma gas including the active species may sinter the surface of the agglomerated ceramic particles 150 injected into the nozzle part 132.

At 450, as the ceramic particles with the sintered surface are sprayed from the nozzle part toward the substrate in the vacuum chamber, the substrate can be coated. In an embodiment, referring to FIG. 1, the ceramic particles 150 with the surface sintered by the plasma gas may be sprayed through the nozzle part 132 and deposited on the substrate 160. Since the ceramic particles 150 with the sintered surface have a significantly lower deposition loss rate compared to unsintered ceramic particles, the substrate 160 can be easily coated with the ceramic.

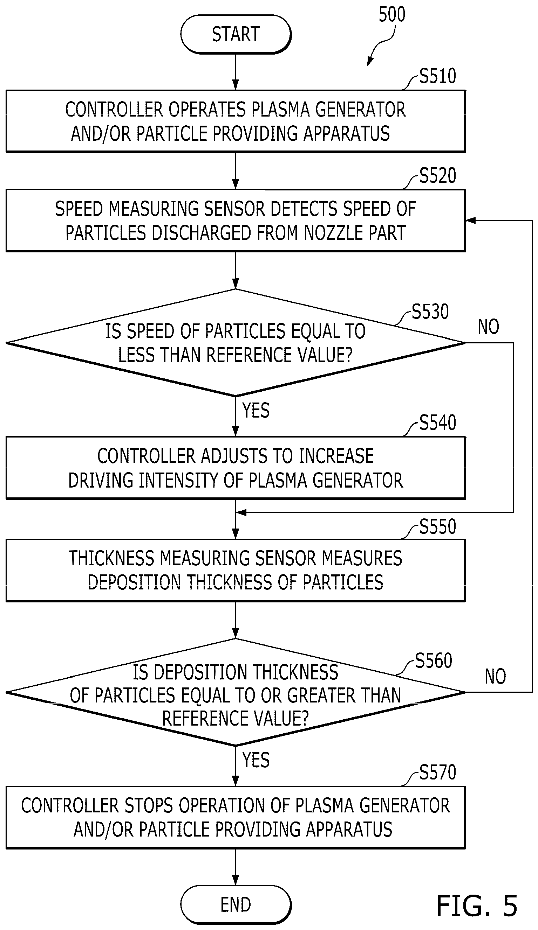

FIG. 5 is a flowchart illustrating a ceramic coating method 500 using the atmospheric pressure plasma generator according to another embodiment.

The ceramic coating method 500 may be initiated by the controller operating the plasma generator and/or the particle providing apparatus, at S510. In an embodiment, referring to FIG. 2, the controller 230 may operate the plasma generator 130 and the particle providing apparatus 140 such that the ceramic particles 150 are discharged to the substrate 160 after being sintered by the plasma gas.

Next, the speed measuring sensor may detect the speed of the ceramic particles discharged from the nozzle part, at S520. In an embodiment, referring to FIG. 2, the speed measuring sensor 210 installed in the vacuum chamber 110 may measure the speed of the ceramic particles 150 discharged from the nozzle unit 132 toward the substrate 160. In addition, the speed measuring sensor 210 may transmit an electrical signal determined according to the moving speed of the ceramic particle 150 to the controller 230.

The controller may determine whether or not the measured moving speed of the ceramic particles is equal to or less than a reference value, at S530. In an embodiment, referring to FIG. 2, the controller 230 may determine whether or not the moving speed of the ceramic particle 150 is equal to or less than a reference value, based on the electrical signal of the speed measuring sensor 210.

When it is determined that the speed measured in step S530 is equal to or less than the reference value, the controller may adjust to increase the driving intensity of the plasma generator, at S540. In an embodiment, referring to FIG. 2, when the controller 230 determines that the moving speed of the ceramic particle 150 is equal to or less than the reference value based on the electrical signal of the speed measuring sensor 210, the controller 230 may adjust to increase the driving intensity of the plasma generator 130. As described above, as the driving intensity of the plasma generator 130 is adjusted upward, the moving speed of the ceramic particles 150 can be increased, and thus the ceramic coating loss rate of the substrate 160 can be reduced.

Next, the thickness measuring sensor may measure the thickness of the ceramic particles deposited on the substrate, at S550. In an embodiment, referring to FIG. 2, the thickness measuring sensor 220 installed in the vacuum chamber 110 may transmit an electrical signal determined according to the thickness of the ceramic particle 150 deposited on the substrate 160 to the controller 230.

The controller may determine whether or not the deposition thickness of the ceramic particles is equal to or greater than a reference value, at S560. In an embodiment, referring to FIG. 2, the controller 230 may determine whether or not the thickness of the ceramic particles 150 deposited on the substrate 160 is equal to or greater than the reference value based on the electrical signal of the thickness measuring sensor 220.

When it is determined that the deposition thickness of the ceramic particles measured at step S560 is equal to or greater than the reference value, the controller may stop the operation of the plasma generator and/or the particle providing apparatus, at S570. In an embodiment, referring to FIG. 2, when the controller 260 determines that the deposition thickness of the ceramic particles 150 deposited on the substrate 160 is equal to or greater than the reference value based on the electrical signal of the thickness measuring sensor 220, the controller 230 may stop the operation of the plasma generator 130 and/or the particle providing apparatus 140. Accordingly, deposition coating of the ceramic particles 150 on the substrate 160 may be ended.

The operations of the controller or the control unit described above may be provided as a computer program stored in a computer-readable recording medium for execution on a computer. The medium may be a type of medium that continuously stores a program executable by a computer, or temporarily stores the program for execution or download. In addition, the medium may be a variety of recording means or storage means having a single piece of hardware or a combination of several pieces of hardware, and is not limited to a medium that is directly connected to any computer system, and accordingly, may be present on a network in a distributed manner. An example of the medium includes a medium configured to store program instructions, including a magnetic medium such as a hard disk, a floppy disk, and a magnetic tape, an optical medium such as a CD-ROM and a DVD, a magnetic-optical medium such as a floptical disk, and a ROM, a RAM, a flash memory, and so on. In addition, other examples of the medium may include an app store that distributes applications, a site that supplies or distributes various software, and a recording medium or a storage medium managed by a server.

The operation, method, or techniques of the controller or the control unit of the present disclosure may be implemented by various means. For example, these techniques may be implemented in hardware, firmware, software, or a combination thereof. Those skilled in the art will further appreciate that various illustrative logical blocks, modules, circuits, and algorithm steps described in connection with the disclosure herein may be implemented in electronic hardware, computer software, or combinations of both. To clearly illustrate this interchangeability of hardware and software, various illustrative components, blocks, modules, circuits, and steps have been described above generally in terms of their functionality. Whether such a function is implemented as hardware or software varies depending on design requirements imposed on the particular application and the overall system. Those skilled in the art may implement the described functions in varying ways for each particular application, but such implementation should not be interpreted as causing a departure from the scope of the present disclosure.

In a hardware implementation, processing units used to perform the techniques may be implemented in one or more ASICs, DSPs, digital signal processing devices (DSPDs), programmable logic devices (PLDs), field programmable gate arrays (FPGAs), processors, controllers, microcontrollers, microprocessors, electronic devices, other electronic units designed to perform the functions described in the disclosure, computer, or a combination thereof.

Accordingly, the controller or the control unit of the present disclosure may be implemented by various illustrative logical blocks, modules, and circuits. For example, the controller or the control unit may be implemented or performed with general purpose processors, DSPs, ASICs, FPGAs or other programmable logic devices, discrete gate or transistor logic, discrete hardware components, or any combination of those designed to perform the functions described herein. The general purpose processor may be a microprocessor, but in the alternative, the processor may be any related processor, controller, microcontroller, or state machine. The processor may also be implemented as a combination of computing devices, for example, a DSP and microprocessor, a plurality of microprocessors, one or more microprocessors associated with a DSP core, or any other combination of the configurations.

In the implementation using firmware and/or software, the techniques may be implemented with instructions stored on a computer-readable medium, such as random access memory (RAM), read-only memory (ROM), non-volatile random access memory (NVRAM), programmable read-only memory (PROM), erasable programmable read-only memory (EPROM), electrically erasable PROM (EEPROM), flash memory, compact disc (CD), magnetic or optical data storage devices, and the like. The instructions may be executable by one or more processors, and may cause the processor(s) to perform certain aspects of the functions described in the present disclosure.

Although the embodiments described above have been described as utilizing aspects of the currently disclosed subject matter in one or more standalone computer devices or systems, embodiments are not limited thereto, and may be implemented in conjunction with any computing environment, such as a network or distributed computing environment. Furthermore, the aspects of the subject matter in the present disclosure may be implemented in multiple processing chips or devices, and storage may be similarly influenced across a plurality of devices. Such devices may include PCs, network servers, and portable devices.

Although the present disclosure has been described in connection with some embodiments herein, various modifications and changes can be made without departing from the scope of the present disclosure, which can be understood by those skilled in the art to which the present disclosure pertains. Further, such modifications and changes are intended to fall within the scope of the claims appended herein.

## Claims

1. A ceramic coating system using an atmospheric pressure plasma generator, comprising:
a vacuum chamber configured to maintain a vacuum therein;
a support disposed inside the vacuum chamber and fixedly supporting a substrate;
a plasma generator that generates active species through plasma discharge, and includes a nozzle part wherein at least a portion of the nozzle part is disposed to face the substrate inside the vacuum chamber; and
a particle providing apparatus that transfers ceramic particles to one side of the nozzle part.

2. The ceramic coating system according to claim 1, wherein a surface of the ceramic particles is sintered by a plasma gas including the active species in the nozzle part, and
as the plasma gas is discharged into the vacuum chamber through the nozzle part, the ceramic particles with the sintered surface are deposited on the substrate.

3. The ceramic coating system according to claim 1, wherein the ceramic particles correspond to ceramic particles used for Aerosol Deposition (AD).

4. The ceramic coating system according to claim 1, wherein the particle providing apparatus includes:
a passage part connected at one side to the nozzle part and configured to move the ceramic particles to the nozzle part using a carrier gas injected from the other side; and
a containing part configured to contain the ceramic particles therein and provide the ceramic particles to the passage part.

5. The ceramic coating system according to claim 1, wherein the support includes a robot arm that fixedly supports the substrate at one end, and
the robot arm is configured to adjust a distance between the nozzle part and the substrate.

6. The ceramic coating system according to claim 1, further comprising:
a speed measuring sensor configured to measure an ejection speed of the ceramic particles in the vacuum chamber; and
a controller that controls a driving intensity of the plasma generator based on the ejection speed measured by the speed measuring sensor.

7. The ceramic coating system according to claim 1, further comprising:
a thickness measuring sensor configured to measure a thickness of the ceramic particles deposited on the substrate; and
a controller that controls whether or not the plasma generator and the particle providing apparatus are driven, based on the deposition thickness of the ceramic particles measured by the thickness measuring sensor.

8. A ceramic coating method using an atmospheric pressure plasma generator, comprising:
by a plasma generator including a nozzle part, plasma-discharging a discharge gas to generate active species;
by a particle providing apparatus, injecting ceramic particles to one side of the nozzle part formed inside a vacuum chamber;
sintering a surface of the ceramic particles by the active species in the nozzle part; and
spraying the ceramic particles with the sintered surface through the nozzle part for deposition coating on a substrate in the vacuum chamber.

9. The ceramic coating method according to claim 8, further comprising adjusting a distance between the nozzle part and the substrate by a support that fixedly supports the substrate from one side.

10. The ceramic coating method according to claim 8, further comprising:
by a speed measuring sensor, measuring an ejection speed of the ceramic particles in the vacuum chamber;
by a thickness measuring sensor, measuring a thickness of the ceramic particles deposited on the substrate;
by a controller, controlling a driving intensity of the plasma generator based on the ejection speed measured by the speed measuring sensor; and
by the controller, controlling whether or not the plasma generator and the particle providing apparatus are driven, based on the deposition thickness of the ceramic particles measured by the thickness measuring sensor.
